# EUROPÄISCHE PATENTANMELDUNG

(11) **EP 2 387 154 A1**
(43) Veröffentlichungstag der Anmeldung: **16.11.2011**
(21) Anmeldenummer: 11165726.8
(22) Anmeldetag: 11.05.2011
(51) Int. Cl.: H03K 17/689, H04L 25/02

(54) **Schaltung zur galvanischen Trennung von Stromkreisen**

(30) Priorität: 12.05.2010 CH 7462010
(71) Anmelder: Aquametro AG, 4106 Therwil (CH)
(72) Erfinder: Schulz, Wolfgang, 4411 Seltisberg (CH)
(74) Vertreter: Braun, André jr.

(57) **Zusammenfassung**

Zur galvanischen Trennung zweier, auf unterschiedlichen Bezugspotentialen arbeitender Stromkreise, zwischen denen elektrische Impulse übertragen werden,dient eine kapazitive Brückenschaltung aus vier in Form einer H-Brücke angeordneten Kondensatoren (5-8), die seriell und parallel nicht abgeglichen ist.

## Beschreibung

Die Erfindung betrifft eine Schaltung zur galvanischen Trennung zweier Stromkreise, die auf unterschiedlichen Bezugspotentialen arbeiten und zwischen denen elektrische Impulse übertragen werden.

Unter dem Begriff "galvanische Trennung" wird für den Zweck dieser Beschreibung eine elektrische Trennung zweier Stromkreise derart, dass keine elektrisch leitende Verbindung zwischen ihnen besteht, so dass keine Ladungsträger von einem Stromkreis in den anderen fliessen können. Elektrische Signale können hingegen beim Vorhandensein geeigneter Kopplung übertragen werden.

In der Messtechnik ist galvanische Trennung unter anderem vor allem dann wichtig, wenn zwei Stromkreise, zwischen denen elektrische Messsignale übertragen werden sollen, auf unterschiedlichen Bezugspotentialen arbeiten und sich gegenseitig nicht beeinflussen dürfen.

Es sind verschiedene Massnahmen zur galvanischen Trennung bekannt. Zu den häufigsten gehören optische Verfahren d.h. Leuchtdioden (LEDs) als Sender und Phototransistoren als Empfänger wie bei Optokopplern oder Glasfaserverbindungen, oder induktive Verfahren, d.h. Transformatoren oder induktive Übertrager. Diese galvanischen Trennungen haben jedoch gravierende Nachteile. Sie benötigen entweder viel Energie zur Versorgung einer LED oder zusätzlichen schaltungstechnischen Aufwand bei der Übertragung von Gleichspannungssignalen über eine induktive Komponente.

Der Erfindung liegt die Aufgabe zugrunde, eine galvanische Trennung unter Vermeidung der bei bekannten Systemen vorhandenen Nachteile zu ermöglichen.

Erfindungsgemäss wird dies erreicht durch eine Schaltung der eingangs erwähnten Art, die sich auszeichnet durch eine kapazitive Brückenschaltung aus vier in Form einer H-Brücke angeordneten Kondensatoren, die seriell und parallel nicht abgeglichen ist.

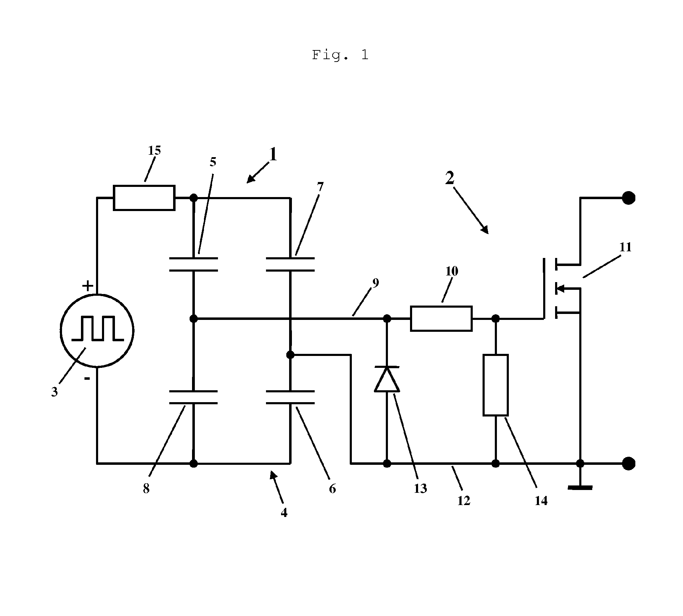

Im Folgenden wird anhand der beiliegenden Zeichnung ein bevorzugtes Ausführungsbeispiel der Erfindung beschrieben. Die Zeichnung zeigt ein Schaltschema einer kapazitiven Brückenschaltung gemäss der Erfindung.

Die in der Zeichnung gezeigte Schaltung besteht aus einem ersten Stromkreis 1 und einem zweiten Stromkreis 2. Die beiden Stromkreise sind galvanisch voneinander getrennt, d.h. sie sind durch keine elektrisch leitende Verbindung miteinander verbunden.

Im ersten Stromkreis 1 ist ein Impulsgenerator 3 gezeigt, der stellvertretend für einen beliebigen Impulsausgang steht, beispielsweise den Impulsausgang eines Mikrocontrollersystems.

Die Übertragung der elektrischen Impulse vom ersten Stromkreis in den zweiten Stromkreis erfolgt über eine kapazitive Kopplung, die durch eine kapazitive Brückenschaltung 4 gebildet ist. Die Brückenschaltung besteht aus einem ersten Kondensatorpaar 5, 6 mit einer ersten Kapazität und einem zweiten Kondensatorpaar 7, 8 mit einer um ein Vielfaches geringeren zweiten Kapazität. Die kapazitive Brückenschaltung ist somit sowohl seriell als auch parallel nicht abgeglichen.

Je ein Kondensator der beiden Paare ist mit dem positiven Impulsausgang des Generators, der jeweils andere Kondensator jedes Paares mit dem negativen Ausgang des Generators verbunden. Die Brückenschaltung stellt somit eine sog. H-Brücke dar. Die mit dem Generator verbundenen Anschlüsse der Kondensatoren werden hier als deren eingangsseitige Anschlüsse, ihre jeweils anderen Anschlüsse als ausgangsseitig bezeichnet.

Je ein ausgangsseitiger Anschluss jedes Kondensatorenpaars ist über eine Impulsleitung 9 und einen Widerstand 10 mit dem Gate eines Transistors 11, im vorliegenden Fall eines MOSFET, verbunden. Die jeweils anderen ausgangsseitigen Anschlüsse jedes Kondensatorpaars sind über eine Leitung 12 mit dem ausgangsseitigen Bezugspotential verbunden. Zwischen den Leitungen 9 und 12 liegt eine Diode 13. Der Widerstand 10 bildet zusammen mit einem weiteren Widerstand 14 zwischen dem Gate des Transistors und der Leitung 12 einen Spannungsteiler.

Aufgrund der nicht abgeglichenen, kapazitiven Brückenschaltung werden durch das unterschiedliche Lade- und Entladeverhalten der Kondensatoren die Impulsflanken auf den Brückenzweig übertragen. Die übertragenen, nun galvanisch getrennten Impulse werden am Brückenzweig abgegriffen und über die Diode 13 und den Spannungsteiler auf das Gate des MOSFETs 11 geschaltet. Die vorangeschaltete Diode D1 sorgt dafür, dass die übertragenen Impulse in ihrem Spannungsniveau nicht tiefer als die Diodenspannung unter das ausgangsseitige Bezugspotential fallen. Der anschliessende Spannungsteiler sorgt für ein definiertes Schaltverhalten des MOSFETs.

Die Grösse der Kapazitäten wird unter anderem in Abhängigkeit von den zu übertragenden Impulslängen gewählt. Beim vorliegenden Ausführungsbeispiel ist die Schaltung für die Übertragung von Impulsen mit einer Länge von 50 Millisekunden ausgelegt. Für diese Impulse betragen die Kapazitäten der Kondensatoren des ersten Paares 5,6 je 470 nF und die Kapazitäten der Kondensatoren des zweiten Paares 7, 8 je 10 nF, d.h. um mindestens einen Faktor 40 weniger. Wenn die Impulslänge kleiner oder grösser ist, können die Kapazitäten kleiner bzw. grösser ausgelegt werden. Der Unterschied zwischen den Kapazitäten der beiden Kondensatorenpaaren kann ebenfalls kleiner, z.B. um einen Faktor 5 oder 10, oder grösser, z.B. um einen Faktor 100 oder 200, sein.

Im ersten Stromkreis ist ein Widerstand 15 mit 1k**Ω**, zur Strombegrenzung beim Laden und Entladen der Kondensatoren vorgesehen.

Die Diode 13 ist eine Standarddiode vom Typ 1N4148. Alternativ kann auch eine Schottky-Diode vom Typ 1N5819 oder eine andere geeignete Diode verwendet werden. Der Widerstand 10 ist niederohmig im Bereich von 1 k**Ω**, der Widerstand 12 hochohmig im Bereich von 10 M**Ω**.

Der Transistor 11 ist ein Logik-MOSFET vom Typ BSS123. Alternativ kommen auch andere Transistoren, v.a. MOSFETs mit sowohl geringer Gate-Source-Spannung V_{gs}, als auch geringem Gate-Source-Charge Q_{gs} in Frage.

Die beschriebene Trennschaltung eignet sich auch zur Übertragung von Rechteck-, Trapez-, Rampen- oder Sinussignalen, sowie auch zur Übertragung von elektrischer Energie.

Der Vorteil dieser kapazitiven Brückenschaltung ist der geringe Energiebedarf zur Übertragung von Schaltsignalen. Es wird lediglich Energie zum Laden und Entladen der Kondensatoren der Brücke und der nachfolgenden Schaltstufe benötigt. Ferner sind die Kosten von vier Standard-Kondensatoren im Vergleich zu einer optischen oder induktiven galvanischen Trennung von Stromkreisen deutlich geringer.

Die beschriebene kapazitive Brückenschaltung kann z.B. in batteriebetriebenen Systemen sowohl die Kapazität und den Platzbedarf einer Batterie verkleinern, als auch die Lebensdauer dieser Systeme verlängern. Ausserdem ist auch der Platzbedarf der kapazitiven Brückenschaltung sehr gering.

## Patentansprüche

1. Schaltung zur galvanischen Trennung zweier Stromkreise, die auf unterschiedlichen Bezugspotentialen arbeiten und zwischen denen elektrische Impulse übertragen werden, **gekennzeichnet durch** eine kapazitive Brückenschaltung aus vier in Form einer H-Brücke angeordneten Kondensatoren, die seriell und parallel nicht abgeglichen ist.

2. Verwendung einer Trennschaltung nach Anspruch 1 zur Übertragung von Rechteck-, Trapez-, Rampen- oder Sinussignalen.

3. Verwendung einer Trennschaltung nach Anspruch 1 zur Übertragung von elektrischer Energie.
